# EUROPEAN PATENT APPLICATION

(11) **EP 4 386 479 A1**
(43) Date of publication of application: **19.06.2024**
(21) Application number: 22212833.2
(22) Date of filing: 12.12.2022
(51) Int. Cl.: G03F 7/00, G02B 26/08

(54) **LITHOGRAPHIC APPARATUS AND ASSOCIATED METHOD**

(71) Applicant: ASML Netherlands B.V., 5500 AH Veldhoven (NL)
(72) Inventor: HARTGERS, Albertus, 5500 AH Veldhoven (NL); STEEGHS, Marco, Matheus, Louis, 5500 AH Veldhoven (NL)
(74) Representative: ASML Netherlands B.V.

(57) **Abstract**

A lithographic apparatus comprises: a support structure; an illumination system; a substrate table configured to support a substrate; and a projection system. The support structure (reticle stage) is configured to support a patterning device such that the patterning device is positionable in an illumination region. The illumination system operable to receive radiation, condition it and to direct at least a portion of the received radiation to the illumination region. The substrate table (wafer stage) is configured to support a substrate. The projection system is operable to form an image of a patterning device supported by the support structure on a substrate supported by the substrate table. The illumination system is configured to control the received radiation such that at least two different portions of the patterning device receive radiation having different angular distributions.

## Description

### FIELD

The present invention relates to a lithographic apparatus. The present invention also relates to a corresponding method of forming a pattern on a target region of a substrate. The lithographic apparatus and method may use extreme ultraviolet (EUV) radiation.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

It is desirable to provide control over various properties of a radiation beam that is used in a lithographic apparatus to project a pattern onto a substrate. For example, it is desirable to monitor an energy of the radiation beam to allow control over a dose of radiation that is delivered to the substrate. Furthermore, it is desirable to provide control over the shape (i.e. the spatial distribution) if the radiation beam in a plane of the patterning device. In addition, it is desirable to provide control over the angular distribution of the radiation beam in a plane of the patterning device. The angular distribution of the radiation beam in a plane of the patterning device may be referred to as an illumination mode this may be chosen in dependence on the pattern being imaged to increase image contrast on the substrate.

It may be desirable to provide new, alternative lithographic apparatus and/or methods that at least partially addresses one or more problems associated with prior art arrangements whether identified herein or otherwise.

### SUMMARY

According to a first aspect of the present disclosure there is provided a lithographic apparatus comprising: a support structure configured to support a patterning device such that the patterning device is positionable in an illumination region; an illumination system operable to receive radiation and to direct at least a portion of the received radiation to the illumination region; a substrate table configured to support a substrate; and a projection system operable to form an image of a patterning device supported by the support structure on a substrate supported by the substrate table; wherein the illumination system is configured to control the received radiation such that at least two different portions of the patterning device receive radiation having different angular distributions.

According to a second aspect of the present disclosure there is provided a lithographic apparatus comprising: a support structure configured to support a patterning device such that the patterning device is positionable in an illumination region; an illumination system operable to receive radiation and to direct at least a portion of the received radiation to the illumination region; a substrate table configured to support a substrate; and a projection system operable to form an image of a patterning device supported by the support structure on a substrate supported by the substrate table; wherein the illumination system is configured to control the received radiation so as to control the angular distribution received across the patterning device.

The lithographic apparatus according to the first and second aspects are advantageous, as now discussed. It is known that optical performance for the printing of a particular feature on a patterning device can be improved, or even optimised, by using illuminating that feature with an appropriate angular distribution of radiation (also referred to as an illumination mode). In general, the pattern on a patterning device (also referred to as a reticle) may comprise a plurality of different features. In known systems the same illumination mode is used over the entire illumination region (also referred to as a slit), the illumination mode being selected so as to achieve reasonable imaging of all of the features in the pattern on the reticle. Advantageously, with the lithographic apparatus according to the first aspect and/or the second aspect, different illumination modes can be used for different portions of patterning device (which may illuminate different types of features to be printed).

The angular distribution of radiation at the patterning device may be referred to as the illumination mode. It may also be referred to as the pupil or pupil fill.

Typically, in existing lithographic apparatus, the illumination mode, or pupil, is (to a good approximation) uniform across the illumination region or slit. In practice there will be small variations of the pupil across the illumination region, for example, due to hardware limitations. However, these variations are typically unwanted, minimised as much as possible, and cannot be steered or controlled. In contrast, the lithographic apparatus according to the first and second aspects provide control over the illumination mode as a function of position on the patterning device. In turn, this can result in improved imaging. For example, in existing arrangements the patterning device may have a plurality of different features and an illumination mode that will provide reasonable, but not optimal, imaging of all of the features may be used such as, for example, an annular illumination mode. An annular illumination mode is known to generally improve the contrast of the image for a range of different features (relative, for example, to a full pupil fill illumination). In contrast, with the lithographic apparatus of the first and second aspects, if some parts of the patterning device only contain one feature (for example lines in a first direction) then an optimal illumination mode (for example an x dipole pupil) may be used for those parts of the patterning device. Furthermore, if some parts of the patterning device only contain another feature (for example lines in a second direction) then a different optimal illumination mode (for example a y dipole pupil) may be used for those parts of the patterning device. For any parts of the patterning device that contain a mixture of features then a general purpose illumination mode (for example an annular pupil) may be used.

The illumination region may comprise a plurality of portions. The illumination system may be configured to control the received radiation such that: a portion of the received radiation directed to each of the plurality of portions of the illumination region has a different angular distribution to that of at least one other of the plurality of portions of the illumination region.

That is, different illumination modes may be used for different portions of the illumination region. For scanning lithographic apparatus (also known as scanners), the different portions of the illumination region may correspond to different positions in a non-scanning direction of the illumination region.

The lithographic apparatus may be a scanner.

The lithographic apparatus may further comprise a scanning mechanism operable to move the support structure relative to the illumination region in a scanning direction so as to move the patterning device supported by the support structure through the illumination region.

That is, the formation of the image of the patterning device on the substrate may be achieved during a scanning exposure in which the patterning device is moved, or scanned, through the illumination region. It will be appreciated that the substrate is also is simultaneously moved, or scanned, through an illumination region at the substrate plane (also referred to as at wafer level).

The illumination system may be operable to control an angular distribution of radiation received by at least a portion of the patterning device during exposure of the patterning device.

That is, different illumination modes may be used for different portions of the illumination regions separated in a scanning direction of the illumination region.

The illumination system may comprise a first optical element and the angular distribution of the radiation at the illumination region may be dependent on a spatial distribution of radiation received by the first optical element.

The first optical element may be referred to as the pupil mirror or the pupil facet mirror.

The first optical element may be disposed such that it is neither in the entrance pupil of the projection system nor in a plane conjugate thereto.

The angular distribution of the radiation at the illumination region is dependent on a spatial distribution of radiation received by the first optical element. However, the mirror array is not disposed in the entrance pupil of the projection system or a plane conjugate thereto. This means that the projection of the entrance pupil of the projection system onto the first optical element via each point of the illumination region maps, in principle, onto a different portion of the first optical element. The inventors have realised that this allows the first optical element to be illuminated so as to create different illumination modes for different portions of the illumination region.

Because the first optical element is not disposed in the entrance pupil of the projection system or a plane conjugate thereto, as observed through the slit, the pupil (which for a given position in the slit is the projection of the entrance pupil onto the first optical element) will vary as across the slit. For example, for embodiments wherein the first optical element comprises a mirror array comprising an array of individually movable mirror facets (some of which are illuminated) the "spots" of the individual mirror facets will appear to move or jump in the pupil plane through the slit. Advantageously, this allows some control over the angular distribution received across the slit (the illumination region).

The first optical element may comprise a mirror array comprising an array of individually movable mirror facets the mirror array arranged to receive radiation and to direct at least a portion of the received radiation to the illumination region. The angular distribution of the radiation at the illumination region may be dependent on which of the array of individually movable mirror facets receives radiation.

The mirror array may be referred to as a pupil facet mirror. It will be appreciated that, since the first optical element is not disposed in the entrance pupil of the projection system or a plane conjugate thereto, the projection of the entrance pupil of the projection system onto the mirror array via each point of the illumination region maps, in principle, onto a different portion of the mirror array (and therefore a different set of the individually movable mirror facets).

Each of the independently movable mirror facets of the first optical element may comprise a micro-electromechanical system (MEMS) micro-mirror.

Therefore, the first optical component may be considered to comprise a MEMS micro-mirror array.

The illumination system may further comprise: a second optical element that is arranged to receive radiation from a radiation source and to direct at least a portion of the received radiation to the first optical element.

The second optical element may be arranged to receive radiation from an intermediate focus or a virtual radiation source.

The second optical element may comprise a second mirror array comprising a two-dimensional array of individually movable mirror facets.

The second mirror array may be referred to as a field facet mirror.

Each of the independently movable mirror facets of the second optical element may comprise a micro-electromechanical system (MEMS) micro-mirror.

Therefore, the second optical component may be considered to comprise a MEMS micro-mirror array.

The second optical element may comprise a plurality of focusing elements having optical power.

Each of the plurality of focusing elements may, for example, be arranged to form an image of an intermediate focus or a virtual radiation source at or proximate to the first optical element (i.e. the pupil facet mirror). For example, each of the focusing elements may comprise a concave mirror.

Each of the plurality of focusing elements may comprise a group or cluster of the of individually movable mirror facets of the two-dimensional array of the second optical element.

For example, each of the focusing elements may comprise a cluster of (for example generally flat) mirror facets that are arranged so as to collectively form a concave mirror.

The first and second optical components may be arranged so as to form an image of each of the focusing elements in the illumination region.

Note that in order to ensure uniformity of the spatial distribution of radiation over the illumination region (which is important for dose control), each position in the illumination region may receive radiation from a plurality of focusing elements. However, in contrast to known arrangements, in embodiments of the present disclosure, in general, each position in the illumination region does not receive radiation from all of the focusing elements.

The second optical element may comprise a plurality of sets of focusing elements, wherein each set of focusing elements is arranged to direct radiation to a different one of a plurality of portions of the illumination region.

Radiation directed by two focusing elements from a given set of focusing elements may overlap spatially at the illumination region and may fill a corresponding portion of the illumination region. Radiation directed by two focusing elements from different sets may have minimal spatial overlap at the illumination region.

Each of the focusing elements within a given set of focusing elements may have substantially the same size and shape.

The radiation directed by the focusing elements from any one of the plurality of sets of focusing elements may overlap spatially at the illumination region.

The radiation directed by the focusing elements from different sets of focusing elements may have minimal spatial overlap at the illumination region.

Each position in the illumination region may receive radiation from a plurality of the plurality of focusing elements.

The illumination system may further comprise: a controller operable to control a configuration of the first optical element and/or a configuration of the second optical element.

The illumination system may be configured to control the received radiation such that at a first portion of the illumination region receives radiation having a first angular distribution and a second portion of the illumination region receives radiation having a second angular distribution.

For example, one end of the illumination region or slit (which may be an elongate region) may receive radiation having the first angular distribution and another end of the illumination or slit may receive radiation having the second angular distribution.

The illumination system may be further configured to control the received radiation such that at a third portion of the illumination region receives radiation having a third angular distribution.

For example, in one embodiment, the illumination mode may be an x-dipole pupil at one end of the slit, a y-dipole pupil at the other end of the slit, and an annular pupil in the centre of the slit.

The illumination region may comprise a plurality of portions. The illumination system may be configured to control the received radiation such that at each of the plurality of portions of the illumination region receives radiation having a different angular distribution to at least one other of the plurality of portions of the illumination region.

According to a third aspect of the present disclosure there is provided an illumination system for the lithographic apparatus according to the first aspect of the present disclosure or the lithographic apparatus according to the second aspect of the present disclosure.

According to a fourth aspect of the present disclosure there is provided a method of forming a pattern on a target region of a substrate, the method comprising: producing a radiation beam; directing at least a portion of the radiation beam to a patterning device so as to impart a pattern to the radiation beam and form a patterned radiation beam; and projecting the patterned radiation beam onto the target region of a substrate; wherein the radiation beam is directed to the patterning device such that at least two different portions of the patterning device receive radiation having different angular distributions.

According to a fifth aspect of the present disclosure there is provided a method of forming a pattern on a target region of a substrate, the method comprising: producing a radiation beam; directing at least a portion of the radiation beam to a patterning device so as to impart a pattern to the radiation beam and form a patterned radiation beam; and projecting the patterned radiation beam onto the target region of a substrate; wherein the method further comprises controlling the angular distribution of radiation received across the patterning device.

The methods according to the fourth and fifth aspects of the present disclosure may be performed using the lithographic apparatus according to the first and/or second aspects of the present disclosure.

Advantageously, with the methods according to the fourth aspect and/or the fifth aspect, different illumination modes can be used for different portions of patterning device (which may illuminate different types of features to be printed). In particular, the methods of the fourth and fifth aspects allow for different illumination modes to be used for different parts of the patterning device, each such illumination mode being optimized for specific features on those parts of the patterning device.

In a plane of the patterning device the radiation beam may comprise a plurality of portions and each of the plurality of portions of the radiation beam may have a different angular distribution to at least one other of the plurality of portions of the radiation beam.

That is, different illumination modes may be used for different portions of the radiation beam (in the plane of the patterning device, i.e. in the illumination region). For scanning lithographic apparatus (also known as scanners), the different portions of the radiation beam may correspond to different positions in a non-scanning direction of the radiation beam.

The method may further comprise moving the patterning device relative to the radiation beam in a scanning direction so as to move the patterning device through the radiation beam.

That is, the formation of the image of the patterning device on the substrate may be achieved during a scanning exposure in which the patterning device is moved, or scanned, through the radiation beam. It will be appreciated that the substrate is also is simultaneously moved, or scanned, through an illumination region at the substrate plane (also referred to as at wafer level).

The method may further comprise controlling an angular distribution of radiation received by at least a portion of the patterning device during exposure of the patterning device.

That is, different illumination modes may be used for different portions of the illumination regions separated in a scanning direction of the illumination region.

The method may be performed using the lithographic apparatus of the first aspect of the present disclosure and/or the lithographic apparatus of the second aspect of the present disclosure.

The radiation beam may be controlled such that in a plane of the patterning device a first portion of the radiation beam has a first angular distribution and a second portion of the radiation beam has a second angular distribution.

For example, one end of the radiation beam in the plane of the patterning device (i.e. the illumination region) may receive radiation having the first angular distribution and another end of the illumination or slit may receive radiation having the second angular distribution.

In the plane of the patterning deice a third portion of the radiation beam may have a third angular distribution.

For example, in one embodiment, the radiation beam may have an x-dipole pupil at one end, a y-dipole pupil at the other end, and an annular pupil in the centre of the radiation beam.

In a plane of the patterning device the radiation beam may comprise a plurality of portions and the radiation beam may be controlled such that each of the plurality of portions of the radiation beam has an angular distribution that is different to the angular distribution of at least one other of the plurality of portions of the radiation beam.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a generally circular portion of the field facet mirror device of the lithographic system shown in Figure 1, showing a central obscuration portion two portions which receive radiation;
- Figure 2B shows an example shape of a field facet for a faceted field mirror device in a known EUV lithographic apparatus of the form shown in Figure 1;
- Figures 3A and 3B show a simplified and schematic representation of a first optical element (or faceted pupil mirror device) that is not disposed in the entrance pupil of a projection system, or a plane conjugate thereto, and the projection (an annulus represented by dashed lines) of the entrance pupil of the projection system onto the first optical element for a first position in an illumination region (see Figure 3A) and a second position in the illumination region (see Figure 3B).
- Figure 4A shows an illumination mode for the first position in the illumination region (as shown in Figure 3A);
- Figure 4B shows an illumination mode for the second position in the illumination region (as shown in Figure 3B);
- Figure 5 is a schematic representation of a first embodiment of an illumination system according to the present disclosure;
- Figure 6 is a schematic representation of a second embodiment of an illumination system according to the present disclosure comprising a second optical element comprising a plurality of sets of focusing elements, each set of focusing elements arranged to direct radiation to a different one of a plurality of portions of an illumination region;
- Figure 7 is a schematic representation of a third embodiment of an illumination system according to the present disclosure comprising a second optical element comprising a plurality of sets of focusing elements, each set of focusing elements arranged to direct radiation to a different one of a plurality of portions of an illumination region; and
- Figure 8 is a schematic diagram of a method according to an embodiment of the present invention.

### DETAILED DESCRIPTION

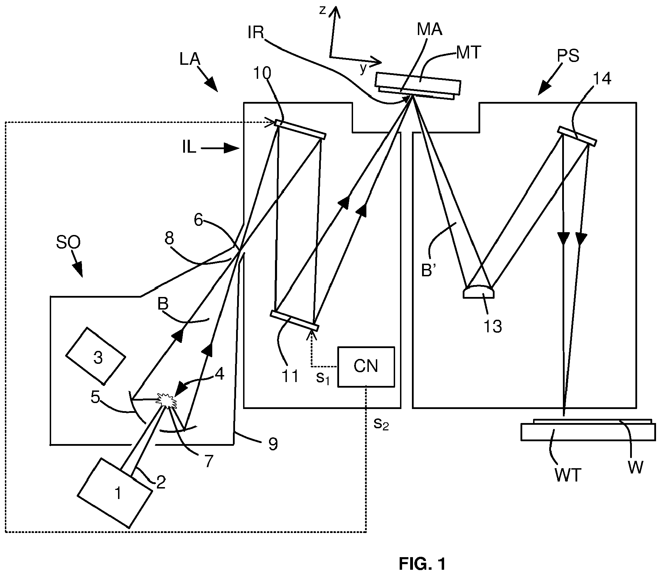

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

The lithographic apparatus LA further comprises a controller CN that is operable to control a configuration of the faceted field mirror device 10 and faceted pupil mirror device 11. To achieve this, the controller CN may be operable to send a suitable control signal si, s₂ to each of the faceted pupil mirror device 11 and the faceted field mirror device 10.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled. In a conventional illumination mode, the radiation uniformly fills a circular region of the illumination pupil plane centred on the optical axis such that each point on the patterning device is illuminated by a solid cone of light. In dipole illumination mode, the radiation fills two regions of the illumination pupil plane that are spaced apart from, and on opposite sides to, the optical axis. Many other illumination modes are known. In principle, an optimum illumination mode can be defined to image a given pattern under given conditions. Therefore, it is desirable to provide flexibility in the illumination mode.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

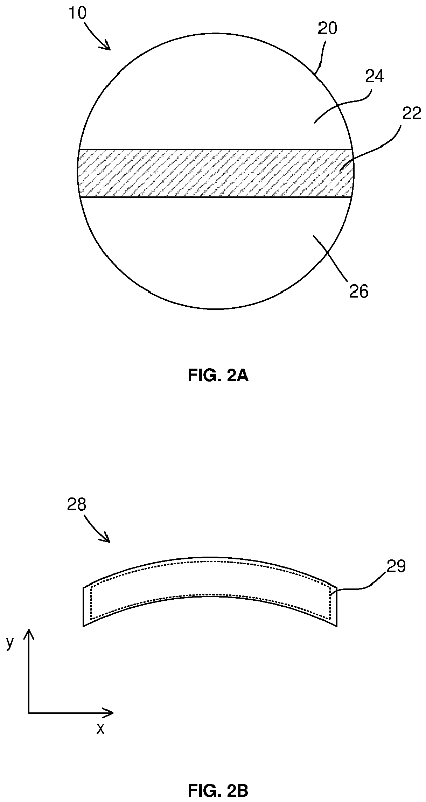

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2A a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

A known faceted field mirror device 10 used in an EUV lithographic apparatus of the type shown in Figure 1 is now described with reference to Figures 2A and 2B.

In known EUV lithographic apparatus, the faceted field mirror device 10 comprises a plurality of field facets. In particular, in such known EUV lithographic apparatus, the portions 24, 26 of the faceted field mirror device 10 that receive radiation from the radiation source SO are provided with a plurality of field facets. For example, the portions 24, 26 of the faceted field mirror device 10 that receive radiation from the radiation source SO may be provided with of the order of 100 field facets (for example 300 field facets). In a plane of the faceted field mirror device 10 each field facet may have a curved shape 28, as shown in Figure 2B. In general, in the plane of the faceted field mirror device 10 each field facet may have an elongate shape having a longer dimension in an x-direction and a shorter dimension in a y-direction. Each field facet comprises a mirror that may be arranged to image the intermediate focus 6 onto the faceted pupil mirror device 11. To achieve this, the field facets may, for example, be concave.

The faceted pupil mirror device 11 comprises a plurality of pupil facets. The faceted pupil mirror device 11 is arranged to project an image of each field facet of the faceted field mirror device 10 onto an illumination region IR (also referred to as the slit or illumination slit) at the patterning device MA. The illumination system IL is configured so that each field facet is imaged on the illumination region IR in an overlapping manner. Desirably, in such known lithographic apparatus, each image of a field facet fills the illumination region IR. The overlap of the images of the field facets at least partially evens out irregularities in the radiation beam B provided by the radiation source SO.

The illumination region IR may be curved or straight. In general, in a scanning lithographic apparatus LA, the illumination region IR is elongate having a longer dimension and a shorter dimension. The shorter dimension may coincide with a scanning direction of the support structure MT and the longer dimension may coincide with a non-scanning direction. The illumination region IR may be curved or straight. The illumination region IR is indicated in Figure 1, which shows the patterning device in cross section. The longer dimension (in the x-direction) of the illumination region IR is perpendicular to the plane of Figure 1 and the shorter dimension (in the y-direction) of the illumination region IR lies in the plane of Figure 1.

It will be appreciated that the illumination region IR may have a shape in the plane of the patterning device MA that generally corresponds to that of each of the field facets, for example being generally of the form of the shape 28 shown in Figure 2B. Note that the shape and size of the projection of each field facet onto the plane of the patterning device MA may not be exactly the same as the illumination region IR and will depend on the magnification factors applied in the x and y directions by the field facet, the pupil facets (and any other optics in upstream of the illumination region IR). The edges of the illumination region IR may be defined by two sets of reticle masking blades (not shown), which may truncate the radiation such that radiation is not incident on the patterning device outside of the illumination region IR. Therefore, in such known lithographic apparatus, each of the field facets may be arranged such that in the absence of such reticle masking blades they would each overfill the illumination region IR. The illumination region IR may receive radiation from a central portion of each field facet, as indicated by the dotted line 29 inside the example shape 28 of a field facet shown in Figure 2B.

Therefore, in some existing EUV lithographic apparatus, a region surrounding the illumination region IR is also provided with EUV radiation (although the illumination region at the patterning device MA is masked from this portion of the EUV radiation, which is not used for exposing the substrate W). This region surrounding the illumination region IR may receive EUV radiation from an edge portion of each field facet mirror (which may be the portion disposed between the dotted line 29 and the edge of shape in the schematic illustration in Figure 2B). At least a part of this portion of the EUV radiation that is not used for exposing the substrate W may be incident on an energy sensor, which may be used to monitor and control a dose of radiation that is delivered to the substrate W.

It has been proposed to use a faceted field mirror device 10 and/or a faceted pupil mirror device 11 having a larger number of individually directable or movable reflective optical elements so as to provide better control over the illumination modes of the lithographic apparatus. For example, it has been proposed to use a faceted field mirror device 10 and/or a faceted pupil mirror device 11 comprising a micro-electromechanical system (MEMS) micro-mirror array.

Embodiments of the present disclosure relate to a lithographic apparatus LA that is generally of the form shown in Figure 1 and described above but wherein the illumination system IL is configured to: (a) control the radiation received by a patterning device MA such that at least two different portions of the patterning device MA receive radiation having different angular distributions; and/or (b) control the radiation received by the patterning device MA so as to control the angular distribution received across the patterning device MA.

Some embodiments of the present disclosure relate to corresponding lithographic methods of of forming a pattern on a target region of a substrate, the method wherein: (a) the radiation beam is directed to the patterning device such that at least two different portions of the patterning device receive radiation having different angular distributions; and or (b) the method comprises controlling the angular distribution of radiation received across the patterning device.

The lithographic apparatus and method according to the present disclosure are advantageous, as now discussed. It is known that optical performance for the printing of a particular feature on a patterning device MA can be improved, or even optimised, by using illuminating that feature with an appropriate angular distribution of radiation (also referred to as an illumination mode). In general, the pattern on a patterning device MA (also referred to as a reticle) may comprise a plurality of different features. In known systems the same illumination mode is used over the entire illumination region IR (also referred to as a slit), the illumination mode being selected so as to achieve reasonable imaging of all of the features in the pattern on the reticle MA. Advantageously, with the lithographic apparatus LA according to the present disclosure, different illumination modes can be used for different portions of patterning device MA (which may illuminate different types of features to be printed).

The angular distribution of radiation at the patterning device MA may be referred to as the illumination mode. It may also be referred to as the pupil or pupil fill.

Typically, in existing lithographic apparatus, the illumination mode, or pupil, is (to a good approximation) uniform across the illumination region IR. In practice, there will be small variations of the pupil across the illumination region IR, for example, due to hardware limitations. However, these variations are typically unwanted, minimised as much as possible, and cannot be steered or controlled. In contrast, the lithographic apparatus LA according to the present disclosure provides control over the illumination mode as a function of position on the patterning device MA. In turn, this can result in improved imaging. For example, in existing arrangements the patterning device MA may have a plurality of different features and an illumination mode that will provide reasonable, but not optimal, imaging of all of the features may be used such as, for example, an annular illumination mode. An annular illumination mode is known to generally improve the contrast of the image for a range of different features (relative, for example, to a full pupil fill illumination). In contrast, with the lithographic apparatus of the present disclosure, if some parts of the patterning device MA only contain one feature (for example lines in a first direction) then an optimal illumination mode (for example an x dipole pupil) may be used for those parts of the patterning device MA. Furthermore, if some parts of the patterning device only contain another feature (for example lines in a second direction) then a different optimal illumination mode (for example a y dipole pupil) may be used for those parts of the patterning device MA. For any parts of the patterning device that contain a mixture of features then a general purpose illumination mode (for example an annular pupil) may be used.

In some embodiments, the illumination system IL of the lithographic apparatus comprises a first optical element and the angular distribution of the radiation at the illumination region IR is dependent on a spatial distribution of radiation received by the first optical element but the first optical element is not disposed in the entrance pupil of the projection system PS or a plane conjugate thereto. The first optical element may be the faceted pupil mirror device 11 described above.

The angular distribution of the radiation at the illumination region IR is dependent on a spatial distribution of radiation received by the first optical element 11. However, the first optical element 11 is not disposed in the entrance pupil of the projection system PS or a plane conjugate thereto. This means that the projection of the entrance pupil of the projection system PS onto the first optical element 11 via each point of the illumination region IR maps, in general, onto a different portion of the first optical element 11. The inventors have realised that this can allow the first optical element 11 to be illuminated so as to create different illumination modes for different portions of the illumination region IR.

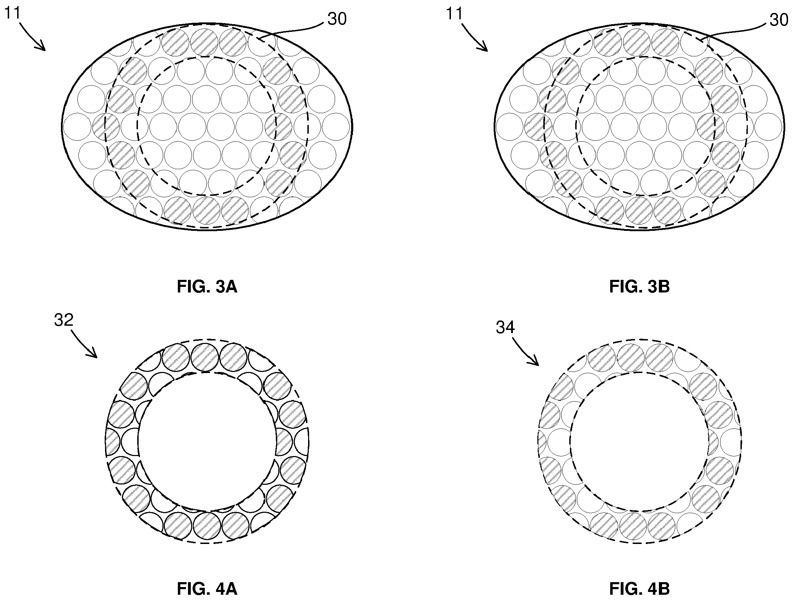

A simplified and schematic representation of the first optical element 11 is shown in Figures 3A and 3B. The first optical element 11 comprises a mirror array comprising an array of individually movable mirror facets (represented as circles). The mirror array 11 is arranged to receive radiation and to direct at least a portion of the received radiation to the illumination region IR. Some of the individual facets receive radiation (from a second optical element 10) and these are represented by hatched circles whereas some of the individual facets do not receive radiation and these are represented by empty circles. The angular distribution of the radiation at the illumination region IR is dependent on which of the array of individually movable mirror facets receives radiation. Also shown in Figures 3A and 3B is a projection 30 (an annulus represented by dashed lines) of the entrance pupil of the projection system PS onto the first optical element 11 for a first position in the illumination region IR (see Figure 3A) and a second position in the illumination region IR (see Figure 3B). For a given position in the illumination region IR, the pupil or illumination mode is the projection of the entrance pupil onto the first optical element 11. The illumination mode 32 (i.e. the overlap between the projection 30 and the first optical element 11) for the first position in the illumination region IR (as shown in Figure 3A) is shown in Figure 4A and the illumination mode 34 for the second position in the illumination region IR (as shown in Figure 3B) is shown in Figure 4B.

It will be appreciated that, since the first optical element 11 is not disposed in the entrance pupil of the projection system PS, or a plane conjugate thereto, the projection 30 of the entrance pupil of the projection system PS onto the mirror array 11 via each point of the illumination region IR maps, in general, onto a different portion of the mirror array (and therefore a different set of the individually movable mirror facets).

Because the first optical element 11 is not disposed in the entrance pupil of the projection system PS, or a plane conjugate thereto, as observed through the illumination region IR, the pupil will vary as across the illumination region IR. For example, as can be seen from Figures 3A and 3B, the "spots" of the illuminated individual mirror facets (i.e. the hatched circles) will appear to move or jump in the pupil plane as a function of position in the illumination region IR. Advantageously, this allows some control the angular distribution received across the illumination region IR.

In some embodiments, each of the independently movable mirror facets of the first optical element 11 comprises a micro-electromechanical system (MEMS) micro-mirror. Therefore, for such embodiments, the first optical component 11 may be considered to comprise a MEMS micro-mirror array.

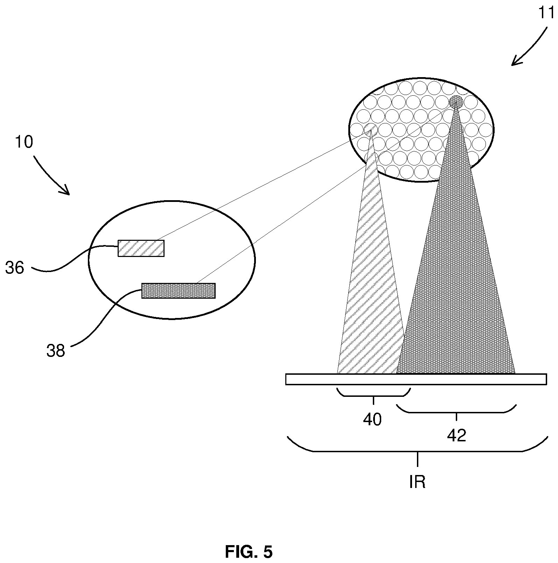

In some embodiments, the illumination region IR comprises a plurality of portions and the illumination system IL is configured to control the received radiation such that the portions of the received radiation directed to the different portions of the illumination region IR have a different angular distributions, as now discussed with reference to Figures 5 to 7. That is, different illumination modes may be used for different portions of the illumination region IR. For scanning lithographic apparatus (also known as scanners), the different portions of the illumination region IR may correspond to different positions in a non-scanning direction of the illumination region (which may be the x-direction).

As explained above, with reference to Figure 1, in some embodiments the illumination system IL further comprises a second optical element 10 that is arranged to receive radiation from a radiation source SO and to direct at least a portion of the received radiation to the first optical element 11. The second optical element may be the faceted field mirror device 10 described above.

The second optical element 10 comprises a second mirror array comprising a two-dimensional array of individually movable mirror facets. In some embodiments, each of the independently movable mirror facets of the second optical element 10 comprises a micro-electromechanical system (MEMS) micro-mirror. Therefore, the second optical component 10 may be considered to comprise a MEMS micro-mirror array. The faceted field mirror device 10 may comprise of the order of 100,000 independently movable reflective optical elements. These reflective optical elements may substantially cover the portions 24, 26 of the faceted field mirror device 10 that receive radiation from the radiation source SO (see Figure 2A and accompanying discussion). In some embodiments, any gaps between adjacent reflective optical elements may be minimal.

In some embodiments, the two-dimensional array of independently movable reflective optical elements provided on the faceted field mirror device 10 may be considered to comprise a plurality of groups of reflective optical elements. Each group of reflective optical elements may comprise a plurality of adjacent independently movable reflective optical elements on the faceted field mirror device 10. Each of the plurality of groups of reflective optical elements may be referred to as a cluster of reflective optical elements.

Such an arrangement wherein a faceted field mirror device 10 comprises a MEMS micro-mirror array has been proposed wherein each group of reflective optical elements may be configured generally to replace one of the field facets discussed above. For example, each group may cover a region of the faceted field mirror device 10 that generally corresponds to the shape of a field facet of an existing faceted field mirror device 10 (for example a region having a shape generally the same as the shape 28 shown in Figure 2B). It will be appreciated that each of the reflective optical elements may be generally square or rectangular in shape and therefore if the group is arranged as a generally curved elongate region of the faceted field mirror device 10 (similar to the shape 28 shown in Figure 2B), the shape may have jagged or pixelated edges along the curved sides of the shape. Furthermore, the orientations of the reflective optical elements within each group may be configured so as to provide an equivalent optical power or concave shape to a field facet of an existing faceted field mirror device 10. Each of the plurality of groups may be referred to as a field facet mirror or a virtual field facet mirror. In these known arrangements, a size and shape of each group of independently movable reflective optical elements may be the same and each group may be imaged onto the entire illumination region IR (in a similar manner to the shape of each of the field facets described above generally corresponding to a shape of the illumination region IR).

In contrast, in embodiments of the present disclosure, the individually movable mirror facets of the two-dimensional array may be arranged differently, as now discussed with reference to Figures 5 to 7.

As shown very schematically in Figure 5, in embodiments of the present disclosure the second optical element 10 may comprise different portions 36, 38 which may be of different sizes and/or shapes and which may be imaged onto different portions 40, 42 of the illumination region IR. This is in contrast to known arrangements wherein the second optical element 10 comprises a plurality of identical facets (or groups of MEMS mirrors which form identical virtual facets) which are all imaged onto the entire illumination region IR.

Each of the plurality of different portions 36, 38 may be considered to be a focusing element having optical power. Each of the plurality of focusing elements 36, 38 may, for example, be arranged to form an image of the intermediate focus 6 (i.e. a virtual radiation source) at or proximate to the first optical element 11 (i.e. the pupil facet mirror).

For example, in some embodiments, each of the focusing elements 36, 38 may comprise a concave mirror (for example one of the field facet mirrors described above in connection with Figure 1).

Alternatively, each of the plurality of focusing elements 36, 38 may comprise a group or cluster of the of individually movable mirror facets of the two-dimensional array. For example, each of the focusing elements may comprise a cluster of (generally flat) mirror facets (for example MEMS mirrors) that are arranged so as to collectively form a concave mirror.

Note that in order to ensure uniformity of the spatial distribution of radiation over the illumination region IR (which is important for dose control), each position in the illumination region IR may receive radiation from a plurality of focusing elements 36, 38 (although only two focusing elements are shown in Figure 5 for ease of understanding, it will be appreciated that in practice there may be of the order of 100 or 1000 focusing elements on the second optical element 10). However, in contrast to known arrangements, in embodiments of the present disclosure, in general, each position in the illumination region IR does not receive radiation from all of the focusing elements 36, 38.

Radiation directed by the two focusing elements 36, 38 shown in Figure 5 partially overlaps spatially at the illumination region IR. However, in contrast to known arrangements, in embodiments of the present disclosure, in general, the radiation directed by two different focusing elements does not substantially cover the illumination region IR and there may be minimal overlap between the radiation directed by two different focusing elements at the illumination region IR.

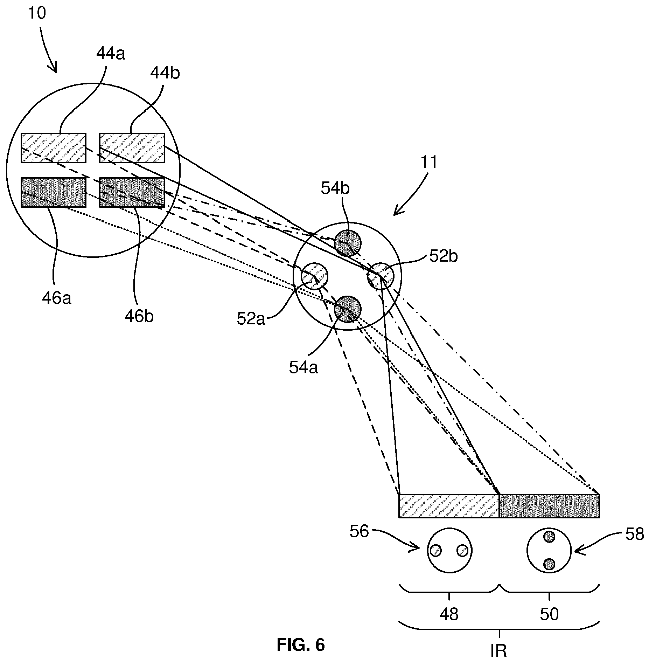

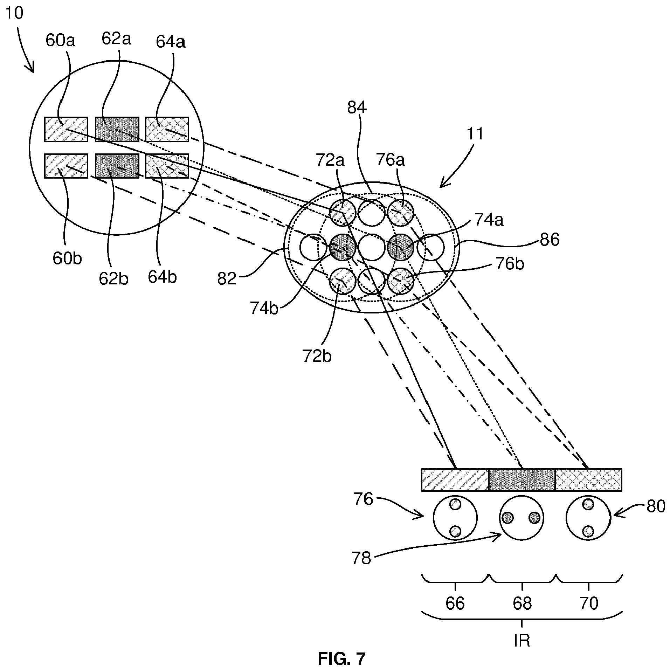

In some embodiments of the present disclosure, the second optical element comprises a plurality of sets of focusing elements. Each set of focusing elements may be arranged to direct radiation to a different one of a plurality of portions of the illumination region IR. Radiation directed by two focusing elements from a given set may overlaps spatially at the illumination region IR and may fill a corresponding portion of the illumination region IR. Radiation directed by two focusing elements from different sets may have minimal spatial overlap at the illumination region IR. Examples of such an arrangement are now discussed with reference to Figures 6 and 7.

In the example shown in Figure 6, the second optical element 10 comprises two sets of focusing elements 44a-44b, 46a-46b. The first set of focusing elements 44a-44b is arranged to direct radiation to a first portion 48 of the illumination region IR. The second set of focusing elements 46a-46b is arranged to direct radiation to a second portion 50 of the illumination region IR. Radiation directed by two focusing elements from a given set (for example focusing elements 44a and 44b or focusing elements 46a and 46b) overlaps spatially at the illumination region IR and may fill a corresponding portion (either 48 or 50) of the illumination region IR. Radiation directed by two focusing elements from different sets has minimal spatial overlap at the illumination region IR.

It will be appreciated that although the focusing elements 44a-44b, 46a-46b and the illumination region IR are shown as being generally rectangular in Figure 6, this is merely for ease of understanding the new arrangement of focusing elements 44a-44b, 46a-46b. In practice, the illumination region IR may match an entrance aperture of the projection system PS and may, for example, be of the form shown in Figure 2B and described above.

The first and second optical components 10, 11 are arranged so as to form an image of each of the focusing elements 44a-44b, 46a-46b in a corresponding portion 48, 50 of the illumination region IR. All such images from a given set overlap spatially at the illumination region IR.

Each of the focusing elements from a given set (for example focusing elements 44a and 44b or focusing elements 46a and 46b) may have substantially the same size and shape (which may be imaged onto the corresponding portion 48, 50 of the illumination region IL).

Although within each of the two sets of focusing elements 44a-44b, 46a-46b, the focusing elements direct radiation to the same portion of the illumination region IR, different focusing elements within each of set of focusing elements directs the radiation via different portions of the first optical element. For example, the two focusing elements 44a, 44b within the first set of focusing elements direct radiation to the first portion 48 of the illumination region IR via two different portions 52a, 52b of the first optical element 11. Similarly, the two focusing elements 46a, 46b within the second set of focusing elements direct radiation to the second portion 50 of the illumination region IR via two different portions 54a, 54b of the first optical element 11.

The pupils 56, 58, or illumination modes, for the two different portions 48, 50 of the illumination region IR are shown below them. In this example, the pupil 56 for the first portion 48 of the illumination region IR is a dipole comprising two poles separated in a first direction (for example, this may be an x-dipole) and the pupil 58 for the second portion 50 of the illumination region IR is a dipole comprising two poles separated in a second direction (for example, this may be an y-dipole).

In the example shown in Figure 6, the illumination system IL (which comprises the first optical element 11 and the second optical element) is configured to control the radiation (received from a radiation source SO and directed to the patterning device MA) such that at a first portion 48 of the illumination region IR receives radiation having a first angular distribution 56 and a second portion 50 of the illumination region IR receives radiation having a second angular distribution 58. In particular, one end of the illumination region IR (for example in a non-scanning direction x) may receive radiation having the first angular distribution 56 and another end of the illumination region IR may receive radiation having the second angular distribution 58.

In the example shown in Figure 6, the first optical element 11 may be disposed in, or close to, the entrance pupil of the projection system PS (or a plane conjugate thereto) as there is not a significant shift in the projection of the entrance pupil of the projection system PS onto the first optical element 11 across the illumination region IR. However, as explained above (with reference to Figures 3A to 4B), in some embodiments, the first optical element 11 may be disposed neither in the entrance pupil of the projection system PS nor in a plane conjugate thereto such that there is a significant shift in the projection of the entrance pupil of the projection system PS onto the first optical element 11 across the illumination region IR. An example of such an embodiment is now described with reference to Figure 7.

In the example shown in Figure 7, the second optical element 10 comprises three sets of focusing elements 60a-60b, 62a-62b, 64a-64b. The first set of focusing elements 60a-60b is arranged to direct radiation to a first portion 66 of the illumination region IR. The second set of focusing elements 62a-62b is arranged to direct radiation to a second portion 68 of the illumination region IR. The third set of focusing elements 64a-64b is arranged to direct radiation to a third portion 70 of the illumination region IR. Radiation directed by two focusing elements from a given set (for example focusing elements 60a and 60b, focusing elements 62a and 62b or focusing elements 64a and 64b) overlaps spatially at the illumination region IR and may fill a corresponding portion (either 66, 68 or 70) of the illumination region IR. Radiation directed by two focusing elements from different sets has minimal spatial overlap at the illumination region IR.

It will be appreciated that although the focusing elements 60a-60b, 62a-62b, 64a-64b and the illumination region IR are shown as being generally rectangular in Figure 7, this is merely for ease of understanding the new arrangement of focusing elements 60a-60b, 62a-62b, 64a-64b. In practice, the illumination region IR may match an entrance aperture of the projection system PS and may, for example, be of the form shown in Figure 2B and described above.

The first and second optical components 10, 11 are arranged so as to form an image of each of the focusing elements 60a-60b, 62a-62b, 64a-64b in a corresponding portion 66, 68, 70 of the illumination region IR. All such images from a given set overlap spatially at the illumination region IR.

Each of the focusing elements from a given set (for example focusing elements 60a and 60b, focusing elements 62a and 62b or focusing elements 64a and 64b) may have substantially the same size and shape (which may be imaged onto the corresponding portion 48, 50 of the illumination region IL).

Although within each of the two sets of focusing elements 60a-60b, 62a-62b, 64a-64b the focusing elements direct radiation to the same portion of the illumination region IR, different focusing elements within each of set of focusing elements directs the radiation via different portions of the first optical element 11. For example, the two focusing elements 60a, 60b within the first set of focusing elements direct radiation to the first portion 66 of the illumination region IR via two different portions 72a, 72b of the first optical element 11. Similarly, the two focusing elements 62a, 62b within the second set of focusing elements direct radiation to the second portion 68 of the illumination region IR via two different portions 74a, 74b of the first optical element 11. Similarly, the two focusing elements 64a, 64b within the third set of focusing elements direct radiation to the third portion 70 of the illumination region IR via two different portions 76a, 76b of the first optical element 11.

The pupils 76, 78, 80, or illumination modes, for the three different portions 66, 68, 70 of the illumination region IR are shown below them. In this example, the pupil 76 for the first portion 76 of the illumination region IR is a dipole comprising two poles separated in a first direction (for example, this may be a y-dipole); the pupil 78 for the second portion 68 of the illumination region IR is a dipole comprising two poles separated in a second direction (for example, this may be an x-dipole); and the pupil 80 for the third portion 70 of the illumination region IR is a dipole comprising two poles separated in the first direction (for example, this may be a y-dipole).

In the example shown in Figure 7, the illumination system IL (which comprises the first optical element 11 and the second optical element 10) is configured to control the radiation (received from a radiation source SO and directed to the patterning device MA) such that at a first portion 68 of the illumination region IR receives radiation having a first angular distribution 76; a second portion 68 of the illumination region IR receives radiation having a second angular distribution 78; and a third portion 70 of the illumination region IR receives radiation having a third angular distribution 80. In particular, one end of the illumination region IR (for example in a non-scanning direction x) receives radiation having the first angular distribution 76, a central portion of the illumination region IR receives radiation having the second angular distribution 78 and another end of the illumination region IR receives radiation having the third angular distribution 80.

In contrast to the example shown in Figure 6 and described above, in the example shown in Figure 7 the first optical element 11 is not disposed in the entrance pupil of the projection system PS (or a plane conjugate thereto). As a result, there is a significant shift in the projection of the entrance pupil of the projection system PS onto the first optical element 11 across the illumination region IR. The projection 82, 84, 86 of the entrance pupil of the projection system PS onto the first optical element 11 for each of the three portions 66, 68, 70 of the illumination region IR (for example for a center of each of the three portions 66, 68, 70) is shown as a dotted line in Figure 7. Advantageously, such an embodiment may allow for a greater variation in the pupil across the illumination region IR as the overlap between the projection of the entrance pupil onto the first optical element 11, at two different positions in the illumination region IR will, in general, be smaller (and therefore this is greater freedom for the pupils for two such positions in the illumination region IR to be different).

In some embodiments the lithographic apparatus LA is a scanner. For such embodiments, the lithographic apparatus LA may further comprising a scanning mechanism operable to move the support structure MT relative to the illumination region IR in a scanning direction (the y-direction in the Figures) so as to move the patterning device MA supported by the support structure MT through the illumination region IR. That is, the formation of the image of the patterning device MA on the substrate W may be achieved during a scanning exposure in which the patterning device MA is moved, or scanned, through the illumination region IR. It will be appreciated that the substrate W is also is simultaneously moved, or scanned, through an illumination region at the substrate plane (also referred to as at wafer level).

For such scanning embodiments, the illumination system IL may be operable to control an angular distribution of radiation received by at least a portion of the patterning device MA during exposure of the patterning device MA. That is, different illumination modes may be used for different portions of the patterning device MA separated in a scanning direction of the lithographic apparatus. For example, in one embodiment, a uniform pupil may be used to illuminate the entire illumination region IR at any given instant but that pupil may change over time during exposure of the patterning device MA. Alternatively, in another embodiment, at any given instant different portions of the illumination region IR may be illuminated with different pupils (for example, as described above with reference to Figures 6 and 7) but the pupil used to illuminate at least a portion of the illumination region may change over time during exposure of the patterning device MA.

Some embodiments of the present disclosure relate to an illumination system IL for the lithographic apparatus LA according to the present disclosure.

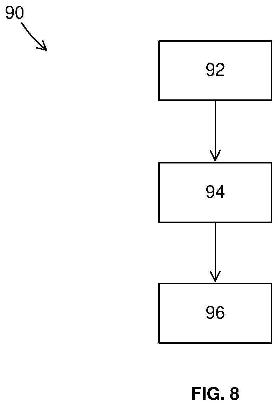

Figure 8 is a schematic diagram of a method 90 of forming a pattern on a target region of a substrate W according to an embodiment of the present disclosure. The method 90 may be implemented using the apparatus shown in Figures 1 to 7 and described above. It will be appreciated that the method 90 may implement any of the functionality of the apparatus shown in Figures 1 to 7 and described above.

The method 90 comprises a step 92 of producing a radiation beam B (for example using a radiation source SO).

The method 90 further comprises a step 94 of directing at least a portion of the radiation beam B to a patterning device MA so as to impart a pattern to the radiation beam B and form a patterned radiation beam B'. Step 94 may, for example, be performed using an illumination system IL.

The method 90 further comprises a step 96 of projecting the patterned radiation beam B' onto the target region of the substrate W.

At step 94, the radiation beam is directed to the patterning device MA such that at least two different portions of the patterning device MA receive radiation having different angular distributions. Additionally or alternatively, at step 94, the method 90 further comprises controlling the angular distribution of radiation B received across the patterning device MA.

Advantageously, with the method 90 shown in Figure 8, different illumination modes can be used for different portions of patterning device MA (which may illuminate different types of features to be printed). In particular, the method 90 allows for different illumination modes to be used for different parts of the patterning device MA, each such illumination mode being optimized for specific features on those parts of the patterning device MA.

In a plane of the patterning device MA the radiation beam B may comprise a plurality of portions, each of the plurality of portions of the radiation beam having a different angular distribution (as described above with reference to Figures 6 and 7). That is, different illumination modes may be used for different portions of the radiation beam B (in the plane of the patterning device MA, i.e. in the illumination region IR). For scanning lithographic apparatus (also known as scanners), the different portions of the radiation beam may correspond to different positions in a non-scanning direction (x-direction) of the radiation beam B.

In some embodiments, step 94 may further comprising moving the patterning device MA relative to the radiation beam B in a scanning direction (y-direction) so as to move the patterning device MA through the radiation beam B. That is, the formation of the image of the patterning device MA on the substrate W may be achieved during a scanning exposure in which the patterning device MA is moved, or scanned, through the radiation beam B. It will be appreciated that (at step 96) the substrate W is also is simultaneously moved, or scanned, through an illumination region IR at the substrate plane (also referred to as at wafer level). For such embodiments, the method 90 may further comprise controlling (or changing) an angular distribution of radiation B received by at least a portion of the patterning device MA during exposure of the patterning device MA. That is, different illumination modes may be used for different portions of the patterning device MA separated in a scanning direction (y-direction) of the lithographic apparatus LA.

At step 94, the radiation B may be controlled such that in a plane of the patterning device MA a first portion of the radiation beam has a first angular distribution and a second portion of the radiation beam has a second angular distribution. For example, one end of the radiation beam B in the plane of the patterning device MA (i.e. the illumination region IR) may receive radiation having the first angular distribution and another end of the illumination region IR may receive radiation having the second angular distribution.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. A lithographic apparatus comprising:
   a support structure configured to support a patterning device such that the patterning device is positionable in an illumination region;
   an illumination system operable to receive radiation and to direct at least a portion of the received radiation to the illumination region;
   a substrate table configured to support a substrate; and
   a projection system operable to form an image of a patterning device supported by the support structure on a substrate supported by the substrate table;
   wherein the illumination system is configured to control the received radiation such that at least two different portions of the patterning device receive radiation having different angular distributions.
2. A lithographic apparatus comprising:
   a support structure configured to support a patterning device such that the patterning device is positionable in an illumination region;
   an illumination system operable to receive radiation and to direct at least a portion of the received radiation to the illumination region;
   a substrate table configured to support a substrate; and
   a projection system operable to form an image of a patterning device supported by the support structure on a substrate supported by the substrate table;
   wherein the illumination system is configured to control the received radiation so as to control the angular distribution received across the patterning device.
3. The lithographic apparatus of example 1 or example 2 wherein the illumination region comprises a plurality of portions and wherein the illumination system is configured to control the received radiation such that: a portion of the received radiation directed to each of the plurality of portions of the illumination region has a different angular distribution to that of at least one other of the plurality of portions of the illumination region.
4. The lithographic apparatus of any preceding example further comprising a scanning mechanism operable to move the support structure relative to the illumination region in a scanning direction so as to move the patterning device supported by the support structure through the illumination region.
5. The lithographic apparatus of example 4 wherein the illumination system is operable to control an angular distribution of radiation received by at least a portion of the patterning device during exposure of the patterning device.
6. The lithographic apparatus of any preceding example wherein the illumination system comprises:
   a first optical element; and
   wherein the angular distribution of the radiation at the illumination region is dependent on a spatial distribution of radiation received by the first optical element.
7. The lithographic apparatus of example 6 wherein the first optical element is not disposed in the entrance pupil of the projection system or a plane conjugate thereto.
8. The lithographic apparatus of example 6 or example 7 wherein the first optical element comprises a mirror array comprising an array of individually movable mirror facets the mirror array arranged to receive radiation and to direct at least a portion of the received radiation to the illumination region and wherein the angular distribution of the radiation at the illumination region is dependent on which of the array of individually movable mirror facets receives radiation.
9. The lithographic apparatus of example 8 wherein each of the independently movable mirror facets of the first optical element comprises a micro-electromechanical system (MEMS) micro-mirror.
10. The lithographic apparatus of any one of examples 6 to 9 wherein the illumination system further comprises: a second optical element that is arranged to receive radiation from a radiation source and to direct at least a portion of the received radiation to the first optical element.
11. The lithographic apparatus of example 10 wherein the second optical element comprises a second mirror array comprising a two-dimensional array of individually movable mirror facets.
12. The lithographic apparatus of example 11 wherein each of the independently movable mirror facets of the second optical element comprises a micro-electromechanical system (MEMS) micro-mirror.
13. The lithographic apparatus of any one of examples 10 to 12 wherein the second optical element comprises a plurality of focusing elements having optical power.
14. The lithographic apparatus of example 13 when dependent either directly or indirectly on example 11 wherein each of the plurality of focusing elements comprises a group or cluster of the of individually movable mirror facets of the two-dimensional array.
15. The lithographic apparatus of example 13 or example 14 wherein the second optical element comprises a plurality of sets of focusing elements, wherein each set of focusing elements is arranged to direct radiation to a different one of a plurality of portions of the illumination region.
16. The lithographic apparatus of example 15 wherein the radiation directed by the focusing elements from any one of the plurality of sets of focusing elements overlaps spatially at the illumination region.
17. The lithographic apparatus of example 15 or example 16 wherein the radiation directed by the focusing elements from different sets of focusing elements have minimal spatial overlap at the illumination region.
18. The lithographic apparatus of any one of examples 13 to 17 wherein each position in the illumination region receives radiation from a plurality of the plurality of focusing elements.
19. The lithographic apparatus of any one of examples 6 to 18 wherein the illumination system further comprises: a controller operable to control a configuration of the first optical element and/or a configuration of the second optical element.
20. The lithographic apparatus of any preceding example wherein the illumination system is configured to control the received radiation such that at a first portion of the illumination region receives radiation having a first angular distribution and a second portion of the illumination region receives radiation having a second angular distribution.
21. The lithographic apparatus of example 20 wherein the illumination system is further configured to control the received radiation such that at a third portion of the illumination region receives radiation having a third angular distribution.
22. The lithographic apparatus of any preceding example wherein the illumination region comprises a plurality of portions and wherein the illumination system is configured to control the received radiation such that at each of the plurality of portions of the illumination region receives radiation having a different angular distribution to at least one other of the plurality of portions of the illumination region.
23. An illumination system for the lithographic apparatus according to any preceding example.
24. A method of forming a pattern on a target region of a substrate, the method comprising:
   producing a radiation beam;
   directing at least a portion of the radiation beam to a patterning device so as to impart a pattern to the radiation beam and form a patterned radiation beam;
   projecting the patterned radiation beam onto the target region of a substrate;
   wherein the radiation beam is directed to the patterning device such that at least two different portions of the patterning device receive radiation having different angular distributions.
25. A method of forming a pattern on a target region of a substrate, the method comprising:
   producing a radiation beam;
   directing at least a portion of the radiation beam to a patterning device so as to impart a pattern to the radiation beam and form a patterned radiation beam;
   projecting the patterned radiation beam onto the target region of a substrate;
   wherein the method further comprises controlling the angular distribution of radiation received across the patterning device.
26. The method of example 24 or example 25 wherein in a plane of the patterning device the radiation beam comprises a plurality of portions and wherein each of the plurality of portions of the radiation beam has a different angular distribution to at least one other of the plurality of portions of the radiation beam.
27. The method of any one of examples 24 to 26 further comprising moving the patterning device relative to the radiation beam in a scanning direction so as to move the patterning device through the radiation beam.
28. The method of example 27 further comprising controlling an angular distribution of radiation received by at least a portion of the patterning device during exposure of the patterning device.
29. The method of any preceding example wherein the method is performed using the lithographic apparatus of any one of examples 1 to 23.
30. The method of any one of examples 24 to 29 wherein the radiation beam is controlled such that in a plane of the patterning device a first portion of the radiation beam has a first angular distribution and a second portion of the radiation beam has a second angular distribution.
31. The method of example 30 wherein in the plane of the patterning deice a third portion of the radiation beam has a third angular distribution.
32. The method of any one of examples 24 to 31 wherein in a plane of the patterning device the radiation beam comprises a plurality of portions and wherein the radiation beam is controlled such that each of the plurality of portions of the radiation beam has an angular distribution that is different to the angular distribution of at least one other of the plurality of portions of the radiation beam.

## Claims

1. An illumination system for a lithographic apparatus, which illumination system is operable to receive radiation and to direct at least a portion of the received radiation to an illumination region of a patterning device;
wherein the illumination system is configured to control the received radiation such that at least two different portions of the patterning device receive radiation having different angular distributions or;
wherein the illumination system is configured to control the received radiation so as to control the angular distribution received across the patterning device.

2. The illumination system of claim 1 wherein the illumination region comprises a plurality of portions and wherein the illumination system is configured to control the received radiation such that: a portion of the received radiation directed to each of the plurality of portions of the illumination region has a different angular distribution to that of at least one other of the plurality of portions of the illumination region.

3. The illumination system of any preceding claim wherein the illumination system comprises:
a first optical element; and
wherein the angular distribution of the radiation at the illumination region is dependent on a spatial distribution of radiation received by the first optical element.

4. The illumination system of claim 3 wherein the first optical element comprises a mirror array comprising an array of individually movable mirror facets the mirror array arranged to receive radiation and to direct at least a portion of the received radiation to the illumination region and wherein the angular distribution of the radiation at the illumination region is dependent on which of the array of individually movable mirror facets receives radiation.

5. The illumination system of any one of claims 3 to 4 wherein the illumination system further comprises: a second optical element that is arranged to receive radiation from a radiation source and to direct at least a portion of the received radiation to the first optical element;
wherein the second optical element comprises a second mirror array comprising a two-dimensional array of individually movable mirror facets.

6. The illumination system of claim 5 wherein each of the independently movable mirror facets of the first or/and second optical element comprises a micro-electromechanical system (MEMS) micro-mirror.

7. The illumination system of any one of claims 5 to 6 wherein the second optical element comprises a plurality of focusing elements having optical power.

8. The illumination system of claim 7 when dependent either directly or indirectly on claim 5 wherein each of the plurality of focusing elements comprises a group or cluster of the of individually movable mirror facets of the two-dimensional array or
wherein the second optical element comprises a plurality of sets of focusing elements, wherein each set of focusing elements is arranged to direct radiation to a different one of a plurality of portions of the illumination region.

9. The illumination system of claim 8 wherein the radiation directed by the focusing elements from any one of the plurality of sets of focusing elements overlaps spatially at the illumination region or wherein the radiation directed by the focusing elements from different sets of focusing elements have minimal spatial overlap at the illumination region.

10. The illumination system of any one of claims 7 to 9 wherein each position in the illumination region receives radiation from a plurality of the plurality of focusing elements.

11. The illumination system of any one of claims 3 to 10 wherein the illumination system further comprises: a controller operable to control a configuration of the first optical element and/or a configuration of the second optical element.

12. The illumination system of any preceding claim wherein the illumination system is configured to control the received radiation such that at a first portion of the illumination region receives radiation having a first angular distribution and a second portion of the illumination region receives radiation having a second angular distribution; wherein the illumination system is further configured to control the received radiation such that at a third portion of the illumination region receives radiation having a third angular distribution.

13. The illumination system of any preceding claim wherein the illumination region comprises a plurality of portions and wherein the illumination system is configured to control the received radiation such that at each of the plurality of portions of the illumination region receives radiation having a different angular distribution to at least one other of the plurality of portions of the illumination region.

14. A lithographic apparatus comprising the illumination system according to any preceding claim.

15. A method of forming a pattern on a target region of a substrate, the method comprising:
producing a radiation beam;
directing at least a portion of the radiation beam to a patterning device so as to impart a pattern to the radiation beam and form a patterned radiation beam;
projecting the patterned radiation beam onto the target region of a substrate;
wherein the radiation beam is directed to the patterning device such that at least two different portions of the patterning device receive radiation having different angular distributions or;
wherein the method further comprises controlling the angular distribution of radiation received across the patterning device.
